# EUROPEAN PATENT SPECIFICATION

(11) **EP 2 250 544 B1**
(45) Date of publication and mention of the grant of the patent: **28.12.2016**
(21) Application number: 09701045.8
(22) Date of filing: 05.01.2009
(51) Int. Cl.: G06F 3/041, G06F 3/01, G06F 3/02

(54) **USER INTERFACE SYSTEM**
BENUTZEROBERFLÄCHENSYSTEM
SYSTÈME D'INTERFACE UTILISATEUR

(30) Priority: 04.01.2008 US 969848
(43) Date of publication of application: 17.11.2010
(73) Proprietor: Tactus Technology, Inc., Mountain View, CA 94041 (US)
(72) Inventor: CIESLA, Craig, Michael, Mountain View CA 94041 (US); YAIRIM, Michah, B., Palo Alto CA 94306 (US)
(74) Representative: Stanners, David Ralph
(86) International application number: PCT/US2009/000037
(87) International publication number: WO 2009/088985

(56) References cited:
- EP-A1- 2 000 884
- WO-A1-2006/082020
- WO-A2-2009/067572
- US-A- 5 943 043
- US-A1- 2003 117 371
- US-A1- 2007 122 314
- US-A1- 2007 296 702
- US-A1- 2008 248 836
- US-A1- 2009 002 328
- US-B1- 6 356 259
- US-B2- 6 636 202

## Description

### TECHNICAL FIELD

This invention relates generally to touch sensitive displays. More particularly, this invention relates to systems and methods for selectively raising portions of touch sensitive displays.

### BACKGROUND

Touch sensitive displays, e.g., touch screens, are very useful in applications where a user can input commands and data directly on a display. Common applications for touch screens include consumer products such as cellular telephones and user interfaces for industrial process control. Depending on their specific applications, these touch sensitive displays are commonly used in devices ranging from small handheld PDAs, to medium sized tablet computers, to large pieces of industrial equipment. Tactical user interface systems are known from WO2009067572, US2003117371, US2008248836, EP2000884, US2009002328 and WO2006082020.

WO2009067572 and US2008248836 disclose a user interface system providing tactile feedback to a user by pumping a fluid into a cavity which expands to deform the upper layer of the system, whereby the system comprises a support member which prevents deformation of the upper layer below the plane of the upper layer when the cavity is not expanded.

US2003117371 discloses a tactile graphic display which provides localized sensory stimulation by pumping a fluid into a cavity to move a stimulus point which can be touched by the user's finger.

EP2000884, US2009002328 and WO2006082020 disclose user interface systems comprising a display layer, a touch sensitive layer and a layer for providing haptic feedback to the user by pumping a liquid into a cavity.

It is often convenient to be able to input and output data to and from the user on the same display. Unlike a dedicated input device such as a keypad with discrete well-defined keys, most touch sensitive displays are generally flat. As a result, touch sensitive screens do not provide any tactile guidance for one or more control "buttons". Instead, touch sensitive displays rely on visual guidance for user input.

Hence a serious drawback of touch sensitive displays is its inherent difficulty to input data accurately because adjacent buttons are not distinguishable by feel. Wrongly entered key strokes are common and the user is forced to keep his or her eyes on the display. The importance of tactile guidance is readily apparent in the competition between the Apple iPhone and the BlackBerry 8800. With a limited size, the mobile phones prior to this invention could include either a large screen or tactile buttons. With this invention, mobile phones and other suitable electronic devices can include both.

The invention resides in a user interface according to claim 1.

### BRIEF DESCRIPTION OF THE FIGURES

FIGURE 1 is a top view of the user interface system of a preferred embodiment.
FIGURE 2 is a cross-sectional view illustrating the operation of a button array in accordance to the preferred embodiments.
FIGURES 3a and 3b are cross-sectional views of the layer, the substrate, the cavity, the touch sensor, and the display of the preferred embodiments, with the cavity in a retracted volume setting and an expanded volume setting, respectively.
FIGURES 4a and 4b are cross-sectional views of the touch sensor located above the substrate, with the cavity in a retracted volume setting and an expanded volume setting, respectively.
FIGURES 5a and 5b are cross-sectional views of the layer and the substrate combined as a singular structure, with the cavity in a retracted volume setting and an expanded volume setting, respectively.
FIGURES 6a and 6b are cross-sectional views of a support member between the layer and the substrate, with the cavity in a retracted volume setting and an expanded volume setting, respectively.
FIGURE 6c is a top view of the support member.
FIGURE 6d is a cross-sectional view of an alternative support member that partially defines the cavity.
FIGURES 7a and 7b are cross-sectional views of the layer, the substrate, the cavity, the touch sensor, the display, and a displacement device that modifies the existing fluid in the cavity, with the cavity in a retracted volume setting and an expanded volume setting, respectively.
FIGURE 8 is a schematic view of the layer, the substrate, the cavity, the touch sensor, the display, and a displacement device of a first example that displaces additional fluid into the cavity.
FIGURE 9 is a schematic view of the layer, the substrate, the cavity, the touch sensor, the display, and a displacement device of a second example that displaces additional fluid into the cavity.
FIGURES 10a and 10b are schematic views of the layer, the substrate, the cavity, the touch sensor, the display, and a displacement device of a third example that displaces additional fluid into and out of the cavity, with the cavity in a retracted volume setting and an expanded volume setting, respectively.
FIGURES 11, 12, 13, 14, and 15 are top and side views of a button deformation, a slider deformation, a slider ring deformation, a guide deformation, and a pointing stick deformation, respectively.
FIGURE 16 is a flow chart of the different operation modes of the preferred embodiments.
FIGURE 17 is a schematic of the different input graphics, different cavity settings, and different user touches of the preferred embodiments.
FIGURES 18a and 18b are schematic views of the cavity and the second cavity connected to a single displacement device, with the cavity in a retracted volume setting and an expanded volume setting, respectively.
FIGURES 19a and 19b are schematic views of the cavity and the second cavity connected to a separate displacement devices, with the cavity in a retracted volume setting and an expanded volume setting, respectively.
FIGURES 20a, 20b, and 20c are schematic views of the cavity and the second cavity connected to a linear actuator, with the cavity in the expanded volume setting and the second cavity in the retracted volume setting, the cavity and the second cavity in the retracted volume setting, and the cavity in the retracted volume setting and the second cavity in the expanded volume setting, respectively.
FIGURE 21a is a schematic view of a first cavity array arranged in a dial pad and a second cavity array arranged in a QUERTY keyboard on the same device.
FIGURES 21b and 21c are schematic views of the display of a dial pad aligned with the first cavity array and a QUERTY keyboard aligned with the second cavity array, respectively.

### DESCRIPTION OF THE PREFERRED EMBODIMENTS

The following description of the preferred embodiments of the invention is not intended to limit the invention to these preferred embodiments, but rather to enable any person skilled in the art to make and use this invention.

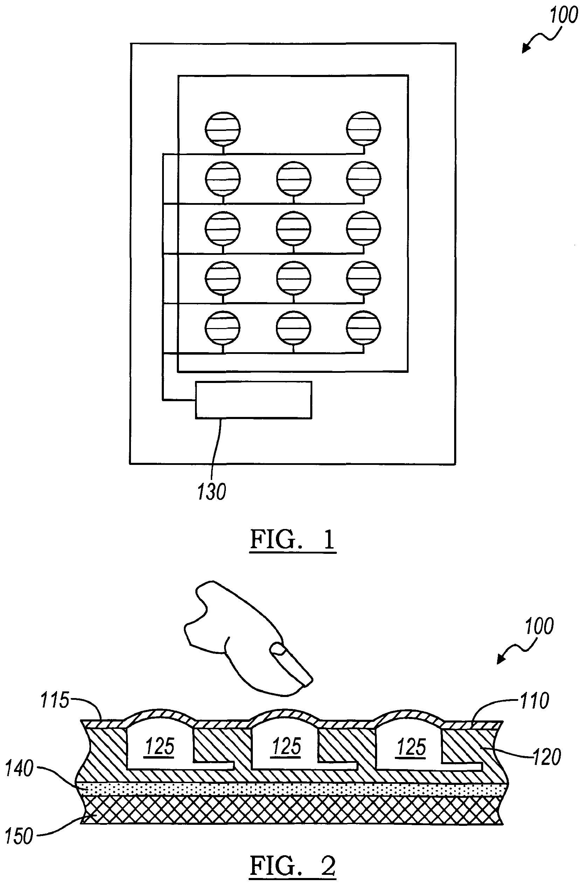

As shown in FIGURES 1 and 2, the user interface system 100 of the preferred embodiment includes: a layer 110 defining a surface 115, a substrate 120 supporting the layer 110 and at least partially defining a cavity 125, a displacement device 130 coupled to the cavity 125 and adapted to expand the cavity 125 thereby deforming a particular region of the surface 115, a touch sensor 140 coupled to the substrate 120 and adapted to sense a user touch proximate the particular region of the surface 115, and a display 150 coupled to the substrate 120 and adapted to output images to the user.

The user interface system 100 of the preferred embodiments has been specifically designed to be incorporated into an electronic device, such as the display of an automotive console, a desktop computer, a laptop computer, a tablet computer, a television, a radio, a desk phone, a mobile phone, a PDA, a personal navigation device, a personal media player, a camera, or a watch. The user interface system may, however, be incorporated in any suitable device that interfaces with a user in both a visual and tactile manner.

### 1. The Layer and Substrate

As shown in FIGURE 2, the layer 110 of the preferred embodiment functions to provide the surface 115 that interfaces with a user in a tactile manner. The surface 115 is preferably continuous, such that when swiping a finger across the surface 115 a user would not feel any interruptions or seams. The surface 115 is also preferably planar. The surface 115 is preferably arranged in a flat plane, but may alternatively be arranged in a curved plane. The layer 110 also functions to deform upon an expansion of the cavity 125, and to preferably "relaxes" or "un-deforms" back to a normal planar state upon retraction of the cavity 125. The layer 110 is preferably elastic. In one version, the layer 110 is relatively more elastic in specific areas and relatively less elastic in other areas and is deformed in the relatively more elastic areas. In another version, the layer 110 is generally uniformly elastic. In yet another version, the layer 110 includes or is made of a smart material, such as Nickel Titanium (commonly referred to as "Nitinol"), that has a selective and/or variable elasticity. The layer 110 is preferably optically transparent, but may alternatively be translucent or opaque. In addition to the transparency, the layer 110 preferably has the following properties: a high transmission, a low haze, a wide viewing angle, a minimal amount of back reflectance upon the display 150 (if the display 150 is coupled with the user interface), scratch resistant, chemical resistant, stain resistant, and relatively smooth (not tacky) to the touch. The layer 110 is preferably made from a suitable elastic material, including polymers and silicon-based elastomers such as poly-dimethylsiloxane (PDMS) or RTV Silicon (e.g., RTV Silicon 615). The layer 110 may, however, be made of any suitable material that provides the surface 115 and that deforms. In one version, the layer 110 is a single homogeneous layer less than 1 mm thick (preferably 50 to 200 microns). In another version, the layer 110 may be constructed using multiple layers or coatings from the same material or from different suitable materials.

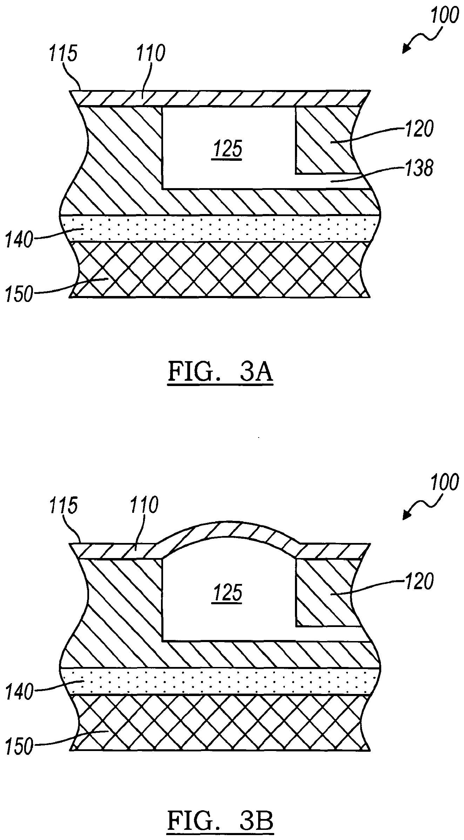

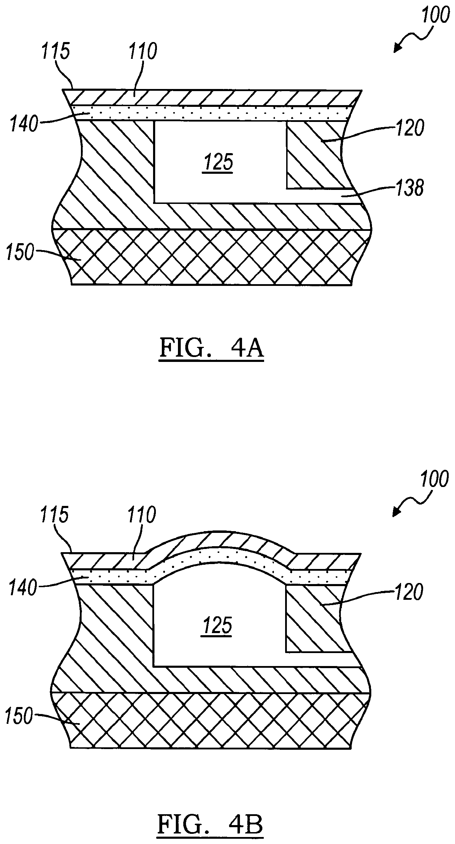

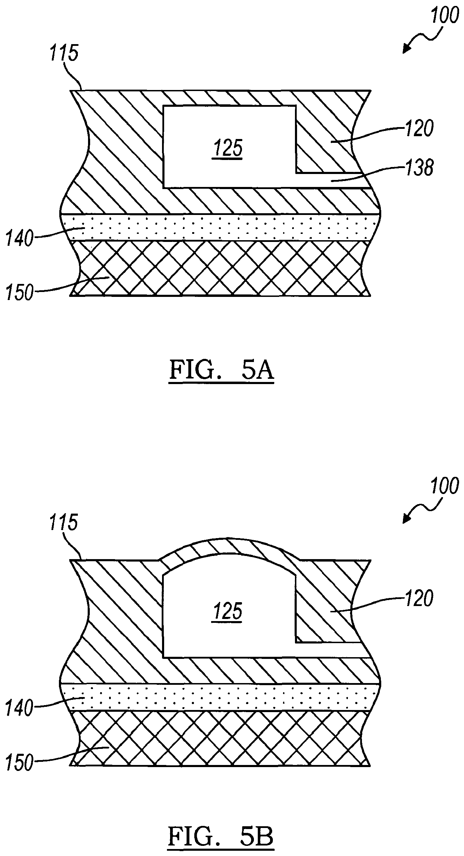

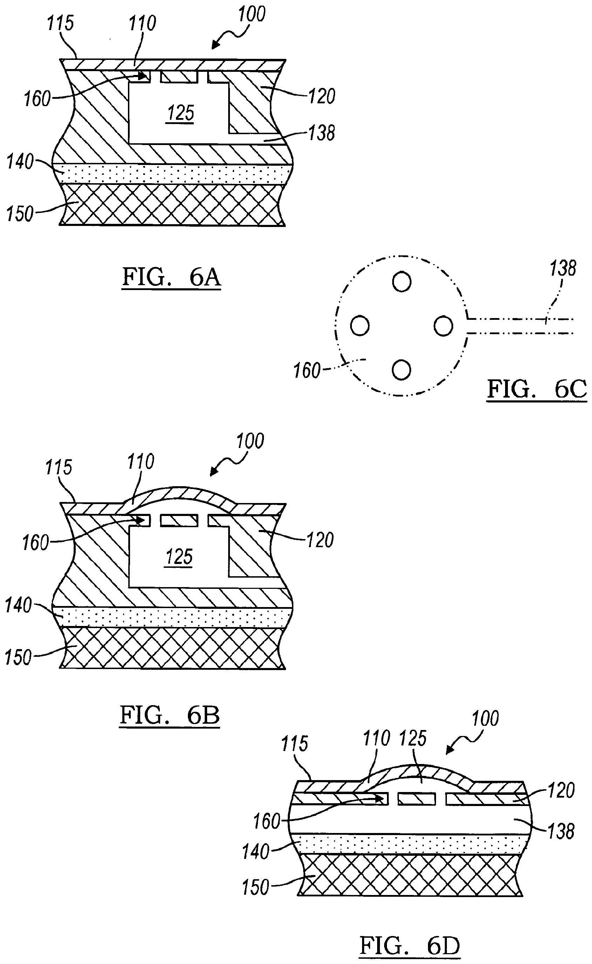

The substrate 120 of the preferred embodiments functions to support the layer 110 and to at least partially define the cavity 125. In one version, as shown in FIGURES 3a and 3b, the layer 110 is directly attached to the substrate 120 using an adhesive, ultra-sonic bonding, oxygen plasma surface treatment, or any other suitable techniques known to one skilled in the art. The substrate 120 and the layer 110, in this version, cooperately define the cavity 125 (with the substrate 120 defining a "container" and the layer 110 defining a "membrane" over the "container"). In another version, as shown in FIGURES 4a and 4b, the layer 110 is indirectly attached to the substrate 120 with another element, such as the touch sensor 140 and/or the display 150 located between the layer 110 and the substrate 120. The substrate 120 and the intervening element define the cavity 125 in this version. In yet another version, as shown in FIGURES 5a and 5b, the layer 110 and the substrate 120 are formed as a singular structure, which fully defines the cavity 125. In yet one more version, as shown in FIGURES 6a and 6b, the substrate 120 may include a lattice-like support member 160 under the particular region of the surface 115. When the cavity 125 is expanded and the deformation is present in the surface 115, the support member 160 functions to prevent a user from "pressing too far" into the deformation below the plane of the surface 115. When the cavity 125 is not expanded and the deformation is not present in the surface 115, the support member 160 functions to reduce (or potentially eliminate) the user from feeling "divots" in the surface 115 when swiping a finger across the surface 115. As shown in FIGURE 6c, the support member 160 preferably includes holes or channels that allow for the expansion of the cavity 125 and the deformation of the surface 115. The support member 160 is preferably integrally formed with the substrate 120, but may alternatively be formed with the layer 110 or may be separately formed and later attached to the substrate 120. Finally, as shown in FIGURE 6d, the support member 160 may alternatively partially define the cavity 125. The substrate 120 is preferably rigid, but may alternatively be flexible in one or more directions. The substrate 120 - if located above the display 150 - is preferably optically transparent, but may - if located below the display 150 or if bundled without a display 150 - be translucent or opaque. The substrate 120 is preferably made from a material including polymers or glass, for example, elastomers, silicon-based organic polymers such as poly-dimethylsiloxane (PDMS), thermoset plastics such as polymethyl methacrylate (PMMA), and photocurable solvent resistant elastomers such as perfluropolyethers. The substrate 120 may, however, be made of any suitable material that supports the layer 110 and at least partially defines the cavity 125. In the preferred version, the substrate 120 is a single homogenous layer approximately 1mm to 0.1 mm thick and can be manufactured using well-known techniques for micro-fluid arrays to create one or more cavities and/or micro channels. In alternative versions, the substrate 120 may be constructed using multiple layers from the same material or from different suitable materials.

As shown in FIGURES 3a and 3b, the cavity 125 of the preferred embodiment functions to hold a fluid and to have at least two volumetric settings: a retracted volume setting (shown in FIGURE 3a) and an extended volume setting (shown in FIGURE 3b). The fluid is preferably a liquid (such as water, glycerin, or ethylene glycol), but may alternatively be a gas (such as air, nitrogen, or argon) or any other substance (such as a gel or aerogel) that expands the cavity 125 and deforms the surface 115. In the extended volume setting, the cavity 125 extends above the plane of the surface 115, thereby deforming a particular region of the surface 115. As explained above, the cavity 125 is preferably defined by the substrate 120 and the layer 110 (or an intervening element), or by the substrate 120 and layer 110 as a singular structure. In one version, as shown in FIGURES 6a and 6b and as further explained below, the cavity 125 does not have any fluidic connection to any other elements of the user interface system 100. The displacement device 130, in this version, may be located within or adjacent to the cavity 125. In another version, the cavity 125 includes a fluidic connection via a channel to a (remotely located) displacement device 130. In both cases, the cavity 125 can be considered an "enclosed cavity" since the cavity 125 is preferably fluid tight (except for any fluidic connections to the displacement device 130). When used with a mobile phone device, the cavity 125 preferably has a diameter of 2-10mm. When used with this or other applications, however, the cavity 125 may have any suitable dimension.

### 2. The Displacement Device

The displacement device 130 of the preferred embodiment functions to modify the volume of the fluid thereby expanding the cavity 125 from the retracted volume setting to the extended volume setting and, ultimately, deforming a particular region of the surface 115. The displacement device 130 preferably modifies the volume of the fluid by (1) modifying the volume of the existing fluid in the cavity 125, or (2) adding and removing fluid to and from the cavity 125. The displacement device 130 may, however, modify the volume of the fluid by any suitable device or method. Modifying the volume of the existing fluid in the cavity 125 most likely has an advantage of lesser complexity, while adding and removing fluid to and from the cavity 125 most likely has an advantage of maintaining the deformation of the surface 115 without the need for additional energy (if valves or other lockable mechanisms are used). When used with a mobile phone device, the displacement device 130 preferably increases the volume of the fluid within the cavity 125 by approximately 0.003-0.1 ml. When used with this or other applications, however, the volume of the fluid may be increased (or possibly decreased) by any suitable amount.

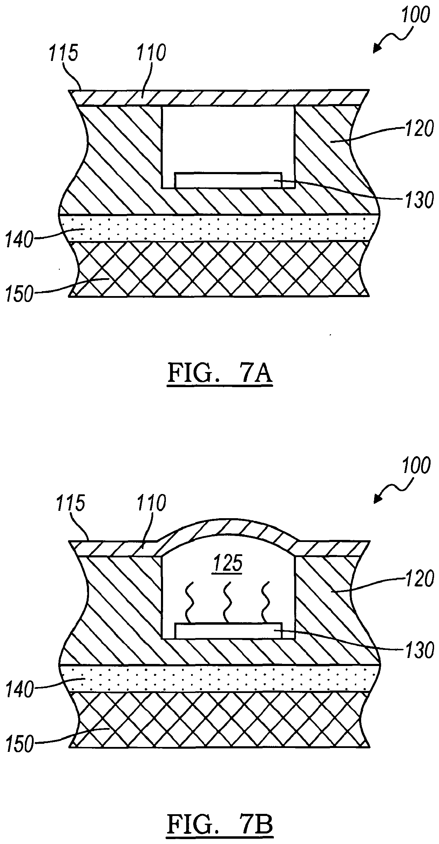

Modifying the existing fluid in the cavity 125 may be accomplished in several ways. In a first example, as shown in FIGURES 7a and 7b, the fluid may be an expandable fluid and the displacement device 130 may include a heating element that heats the expandable fluid, thereby expanding the volume of the existing fluid in the cavity 125 (according to the ideal gas law, PV=nRT). The heating element, which may be located within or adjacent the cavity 125, is preferably a resistive heater (made of a material such as TaN or Nichrome). In a second example, the fluid may include an expandable substance, such as plastic expandable microspheres. In a third example, the fluid may include paraffin. While these are three examples, the displacement device 130 can be any other suitable device or method that ultimately expands the cavity 125 from the retracted volume setting to the extended volume setting by modifying the existing fluid in the cavity 125.

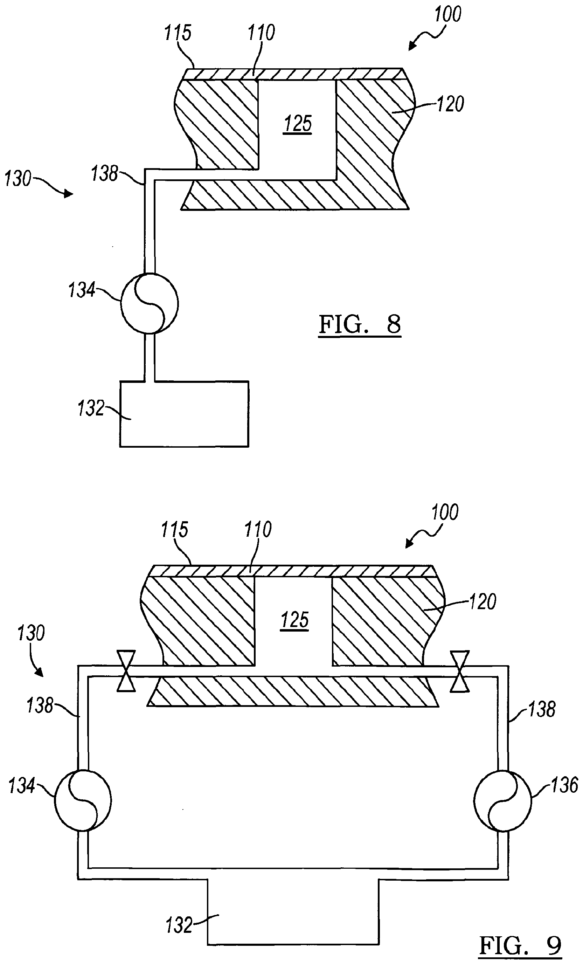

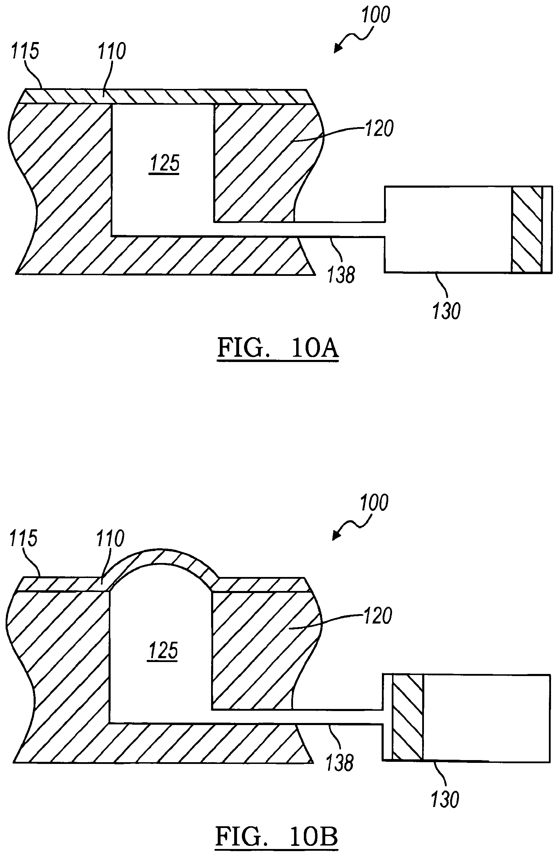

Adding and removing fluid to and from the cavity 125 may also be accomplished in several ways. In a first example, as shown in FIGURE 8, the displacement device 130 includes a reservoir 132 to hold additional fluid and a pump 134 to displace fluid from the reservoir 132 to the cavity 125. The reservoir 132 is preferably remote from the cavity 125 (and connected by a channel 138 or other suitable device), but may alternatively be located adjacent the cavity 125 and connected directly to the cavity 125. A portion of the channel 138 is preferably a micro-fluidic channel (having cross-section dimensions in the range of 1 micrometer to 1000 micrometers), but depending on the size and costs constraints of the user interface system 100, the channel 138 may have any suitable dimensions. The pump 134 is preferably a micro-pump (such as pump #MDP2205 from ThinXXs Microtechnology AG of Zweibrucken, Germany or pump #mP5 from Bartels Mikrotechnik GmbH of Dortmund, Germany), but may be any suitable device to pump fluid from one location to another. The pump 134 is preferably located at a distance from the cavity 125, and is preferably connected to the cavity 125 by a channel 138. To extend the cavity 125 from a retracted volume setting to the extended volume setting, the pump 134 displaces fluid from a reservoir 132, through the channel 138, and into the cavity 125. To retract the cavity 125 from the extended volume setting to the retracted volume setting, the pump 134 preferably "vents" or pumps in a reverse direction from the cavity 125 to the reservoir 132. In a second example, as shown in FIGURE 9, the displacement device 130 includes a reservoir 132 to hold additional fluid, a first pump 134 to displace fluid from the reservoir 132 to the cavity 125, a second pump 136 to displace fluid from the cavity 125 to the reservoir 132, a first valve located between the first pump 134 and the cavity 125, and a second valve located between the cavity 125 and the second pump 136. To extend the cavity 125 from the retracted volume setting to the extended volume setting, the first valve is opened, the second valve is closed, and the first pump 134 displaces fluid from the reservoir 132, through the channel 138, and into the cavity 125. To retract the cavity 125 from the extended position to the retracted position, the first valve is closed, the second valve is opened, and the second pump 136 displaces fluid from the cavity 125, through the channel 138, and into the reservoir 132. In other respects, the second example is similar to the first example above. The user interface system 100 may omit the second pump 136 and simply retract the cavity 125 from the extended volume setting to the retracted volume setting by opening the second valve and allowing the cavity 125 to vent or "drain" into the reservoir 132 (potentially assisted by the elasticity of the layer 110 returning to an un-deformed state). In a third example, as shown in FIGURES 10a and 10b, the displacement device 130 includes an actuator, such as a linear actuator, that displaces fluid into and out of the cavity 125. To extend the cavity 125 from a retracted volume setting to the extended volume setting, as shown in FIGURE 10a, the linear actuator displaces fluid through the channel 138 and into the cavity 125. To retract the cavity 125 from the extended volume setting to the retracted volume setting, as shown in FIGURE 10b, the linear actuator draws fluid in a reverse direction from the cavity 125 to the reservoir 132. In other respects, the third example is similar to the second example above. While these are three examples, the displacement device 130 can be any other suitable device or method that ultimately expands the cavity 125 from the retracted volume setting to the extended volume setting by adding and removing fluid to and from the cavity 125.

Although the cause of the deformation of a particular region of the surface 115 has been described as a modification of the volume of the fluid in the cavity 125, it is possible to describe the cause of the deformation as an increase in the pressure below the surface 115 relative to the pressure above the surface 115. When used with a mobile phone device, an increase of approximately 0.1-10.0 psi between the pressure below the layer 110 relative to the pressure above the layer 110, is preferably enough to deform a particular region of the surface 115. When used with this or other applications, however, the modification of the pressure may be increased (or possibly decreased) by any suitable amount.

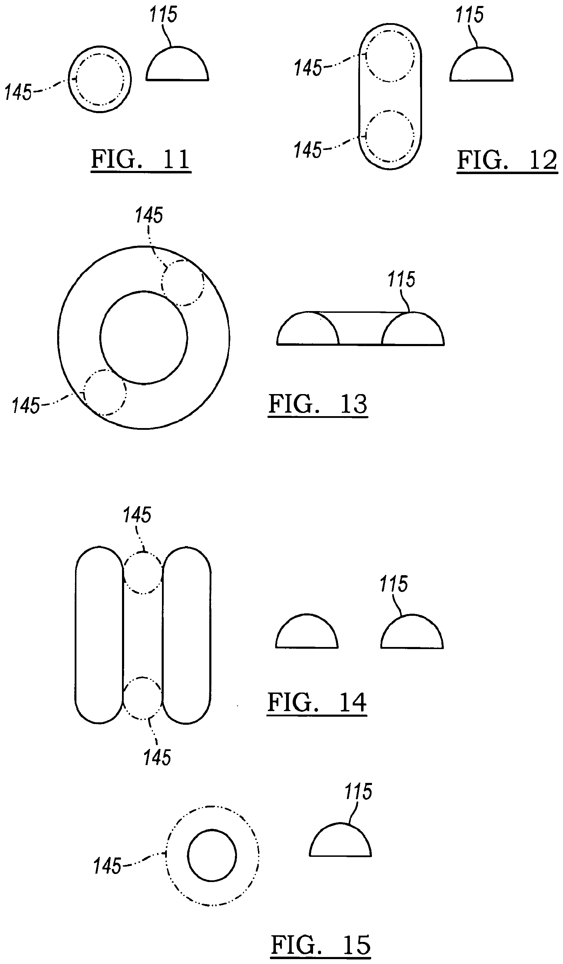

The deformation of the surface 115 functions to provide a tactile feedback that signals the location of the particular region of the surface 115. When used in conjunction with an input graphic on the display 150, the deformation of the surface 115 preferably signals the location of an input on the touch sensor 140. The deformation preferably acts as (1) a button that can be pressed by the user and that signals the location of a single input on the touch sensor 140 under the button, (2) a slider that can be pressed by the user and that signals the location of multiple inputs on the touch sensor 140 under the slider, (3) a guide that signals the location of multiple inputs on the touch sensor 140 adjacent the guide, and (4) a pointing stick that signals the location of multiple inputs on the touch sensor 140 under and adjacent the pointing stick. The deformation may, however, act as any other suitable device or method that signals the location of a particular region of the surface 115. The button, as shown in FIGURE 11, preferably has a dome-like shape, but may alternatively have a cylindrical-like shape (with a flat top surface), a pyramid-like shape, a cube-like shape (with a flat top), or any other suitable button shape. The touch sensor 140 preferably recognizes any user touch 145 into the button as a user input. The slider, as shown in FIGURES 12 and 13, preferably has a ridge like shape (shown in FIGURE 12), but may alternatively have a ring like shape (shown in FIGURE 13), a plus-like shape, or any other suitable slider shape. The touch sensor 140 preferably recognizes user touches 145 at different locations into the slider and distinguishes these user touches as different user inputs. As an example, the slider with the ring like shape may act like the "click wheel" of the Apple iPod (second generation). The guide, as shown in FIGURE 14, preferably has a double ridge shape or a double ring shape. Unlike the button and the slider, which are meant to be pressed by the user, the guide is meant to signal the location next to the area meant to be pressed by the user. The touch sensor 140 preferably recognizes user touches 145 at different locations between the two ridges and distinguishes these user touches as different user inputs. In another version, the guide may omit the second ridge. The pointing stick, like the button, preferably has a dome-like shape, as shown in FIGURE 15, but may alternatively have a cylindrical-like shape (with a flat top surface), a pyramid-like shape, a cube-like shape (with a flat top), or any other suitable button shape. The pointing stick is meant to signal the location under and adjacent the area meant to be pressed by the user. The touch sensor 140 preferably recognizes user touches 145 at different locations under and around the pointing stick and distinguishes these user touches as different user inputs. As an example, the point stick may act like the pointing stick trademarked by IBM as the TRACKPOINT and by Synaptics as the TOUCHSTYK (which are both informally known as the "nipple").

### 3. The Touch Sensor and the Display

The touch sensor 140 of the preferred embodiments functions to sense a user touch proximate the particular region of the surface 115. The touch sensor 140 is preferably located under the substrate 120 (as shown in FIGURES 3a and 3b), but may alternatively be located above the substrate 120 (as shown in FIGURES 4a and 4b). If located above the substrate 120, in addition to sensing a user touch, the touch sensor 140 also functions to deform upon an expansion of the cavity 125 and therefore the touch sensor 140 preferably has elastic properties similar to the layer 110. As a variation of this version, the touch sensor 140 may act as the layer 110 to partially define the cavity 125. The touch sensor 140 preferably senses a user touch in a continuous or multiple step manner. For example, the touch sensor 140 preferably distinguishes a resting user touch (that does not significantly modify the deformation of the surface 115), a gentle user touch (that partially pushes the surface 115 back to the normal, unexpanded plane of the surface 115), and a hard user touch (that completely pushes the surface 115 back to the normal, unexpanded plane of the surface 115). In other words, the touch sensor 140 preferably senses different "heights" of the deformation. The touch sensor 140 may, however, simply sense a user touch in a binary manner ("on" or "off'). In one example, the touch sensor 140 is preferably a conventional capacitance-based touch sensor, such as the touch panel sold by Synaptics under the trademark CLEARPAD, but may be any suitable device that senses a user touch. The capacitance-based touch sensor preferably senses a user touch based on the change in capacitance between two locations within or near the cavity 125. In another example, the touch sensor 140 is a pressure sensor either located in or coupled to the cavity 125. The pressure sensor preferably senses a user touch based on a change in the pressure within the cavity 125 caused by a user touch on the deformation of the surface 115. In yet another example, the touch sensor 140 is integrated with the displacement device 130 to sense either a fluid displacement or a pressure change caused by a user touch on the deformation of the surface 115. While these are three examples, the touch sensor 140 can be any other suitable device or method that senses a user touch proximate the deformation of the surface 115.

The display 150 of the preferred embodiments functions to interface with a user in a visual manner. The display 150 is preferably a conventional liquid crystal display (LCD), but may alternatively any suitable device that displays an output. In one version, as shown in FIGURES 3a and 3b, the display 150 is located under the substrate 120. In another version, the touch sensor 140 and the display 150 may be integrated as a single structure that both senses a user input and displays an output. For example, an LCD with embedded optical sensors both touch screen and scanner functions was announced in a 2007 press release by Sharp Electronics of Japan. This combined touch sensor / display - if flexible - may be located above the substrate 120, and - if not flexible - may be located below the substrate 120. If the display 150 is located below the substrate 120 and the fluid, then the substrate 120 and the fluid are preferably transparent and are preferably chosen to have substantially similar (if not identical) refractive indexes. An example of a substrate 120 and fluid that have substantially similar refractive indexes include: PMMA (which has an index of refraction of 1.489) and the Cargille Laboratories Series A fluids (which cover the range of 1.460-1.640) or a mixture of Diethyl Phthalate and water. When used in mobile phones, "substantially similar" in this context preferably means +/- 0.1 relative to each other. When used in this and other applications, "substantially similar" may alternatively mean similar enough to prevent viewing distortions of the display 150. The display 150 preferably outputs several different visual outputs. One of the outputs is preferably an input graphic that is aligned with the particular region of the surface 115 that can be deformed by the cavity 125 in the extended volume setting. Examples of suitable input graphics include individual letters of a QUERTY keyboard, individual numbers in a dial pad, and different locations on a map.

### 4. The Processor

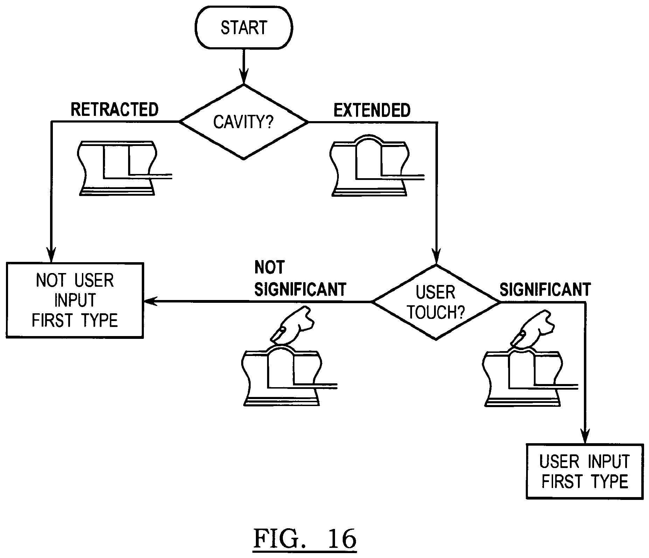

The user interface system 100 of the preferred embodiment also includes a processor, which is coupled to the displacement device 130 and to the touch sensor 140. As shown in FIGURE 16, the processor functions to operate the user interface system 100 in an Extended Cavity Mode and a Retracted Cavity Mode. In the Extended Cavity Mode, if the particular region of the surface 115 is deformed, then a user touch that further significantly deforms the particular region of the surface 115 is preferably recognized as a user input of a first type. A user touch that does not significantly deform the particular region of the surface 115, such as the touch of a user resting their fingers on the deformation, is preferably not recognized as a user input of the first type (and is preferably ignored). In this manner, the deformation of the surface 115 additionally functions to distance the user touch from the touch sensor 140 and to allow the user to rest their fingers on the deformation (the location of an input) without actuating the input. The question of whether a user has significantly or not significantly deformed the particular region of the surface 115 may be set or modified by the manufacturer, by the processor, or by the user. In the Retracted Cavity Mode, if the particular region of the surface 115 is not deformed, then a user touch at the particular region in the surface 115 is preferably not recognized as a user input of the first type, but rather is recognized as a user input of a second type that is distinguishable from a user input of the first type.

The processor may also function to automatically alter the settings of the user interface system 100. In a first example, in extremely low temperatures, it may be impossible for the displacement device 130 to modify the volume of the fluid to expand the cavity 125 and deform the surface 115. The processor may be coupled to a temperature sensor and may disable the displacement device 130 under such conditions. In a second example, in high altitude conditions (or in an airplane with reduced air pressure), it may be impossible for the displacement device 130 to modify the volume of the fluid to retract the cavity 125. The processor may be coupled to a pressure sensor and may either disable the displacement device 130 (or close particular valves), or may simply adjust the volume of the fluid that is modified under such conditions.

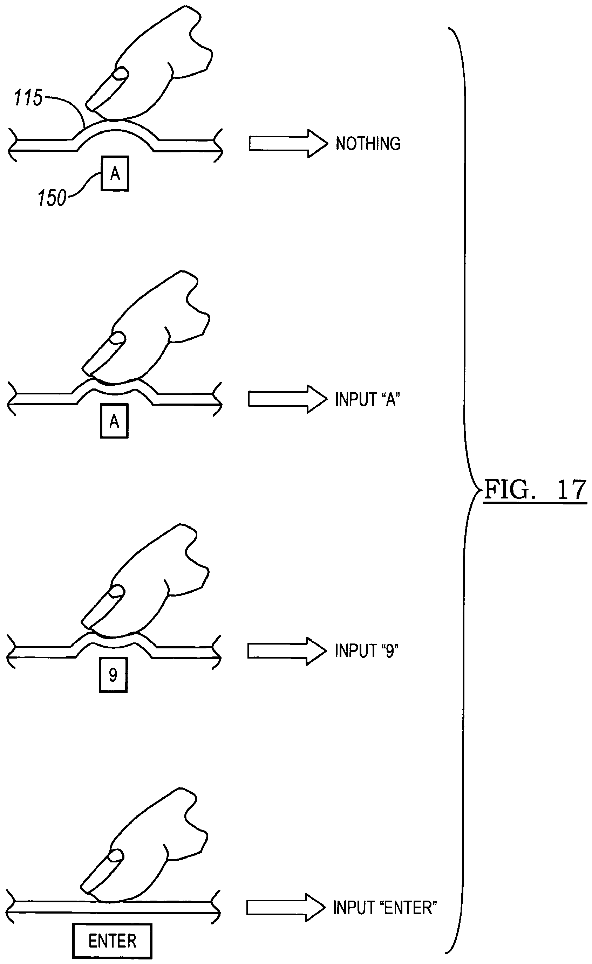

As shown in FIGURE 17, the processor may also be coupled to the display 150 such that different input graphics may be displayed under the same deformation of the surface 115, and different inputs may be recognized. As an example, when the cavity 125 is in the extended volume setting, the display 150 may include an input graphic of a first type (such as a letter) and the user input on the deformation would be of a first type (such as a letter), and the display 150 may include an input graphic of a second type (such as a number) and the user input on the deformation would be of a second type (such as a number). When the cavity 125 is in the retracted volume setting, the display 150 may further include an input graphic of a third type (such as an "enter" or "accept" input), and the user input on the touch sensor 140 would be of a third type (such as an "enter" or "accept" input).

The processor may also function to alter the output of the display 150 to correct or adjust for any optical distortion caused by the deformation in the surface 115. It is envisioned that, in certain applications, the size of the deformation may cause a "fish eye" effect when viewing the display 150. The processor, preferably through empirical data, may adjust the output to help correct for this distortion.

The processor preferably includes a separate and remote controller for the displacement device 130, a separate and remote controller for the touch sensor 140, and a separate and remote controller for the display 150. The processor may, however, integrally include a controller for one or more of these elements.

### 5. Second Cavity

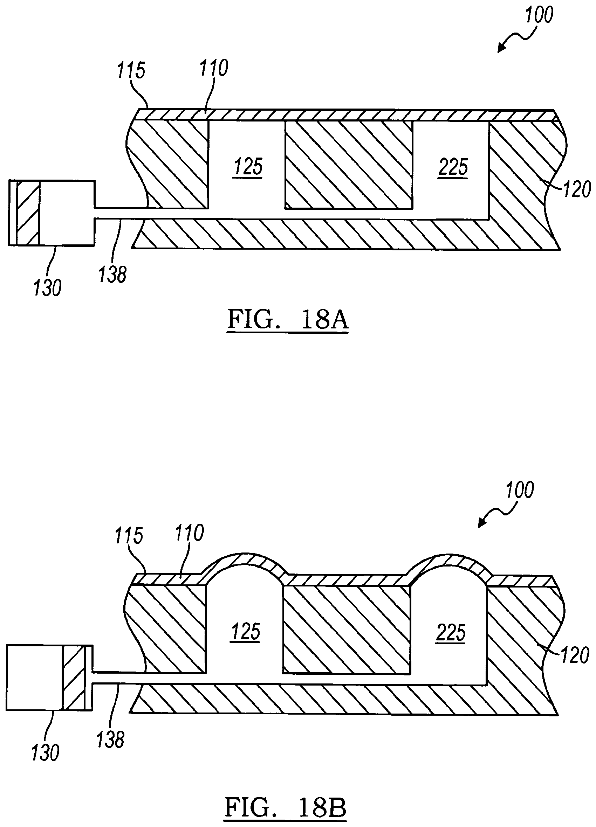

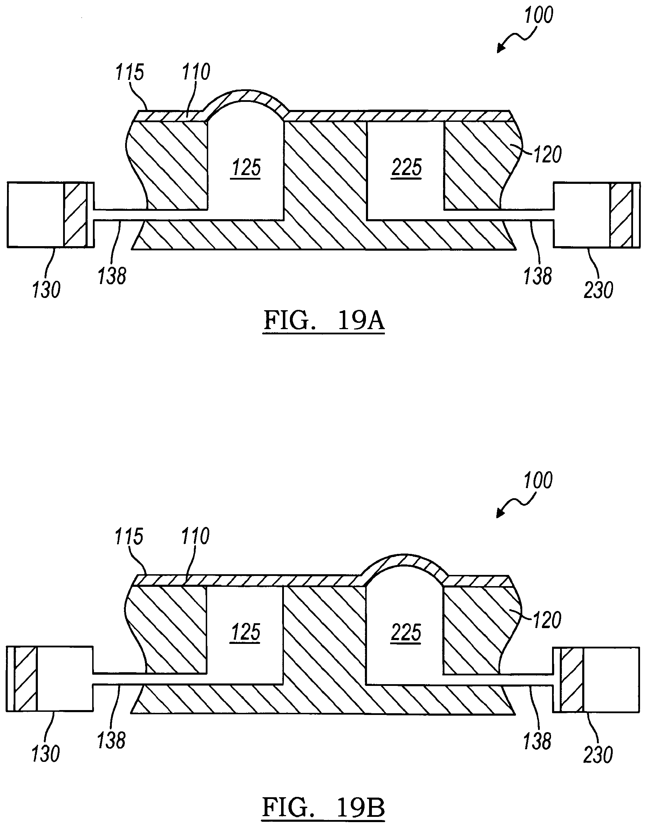

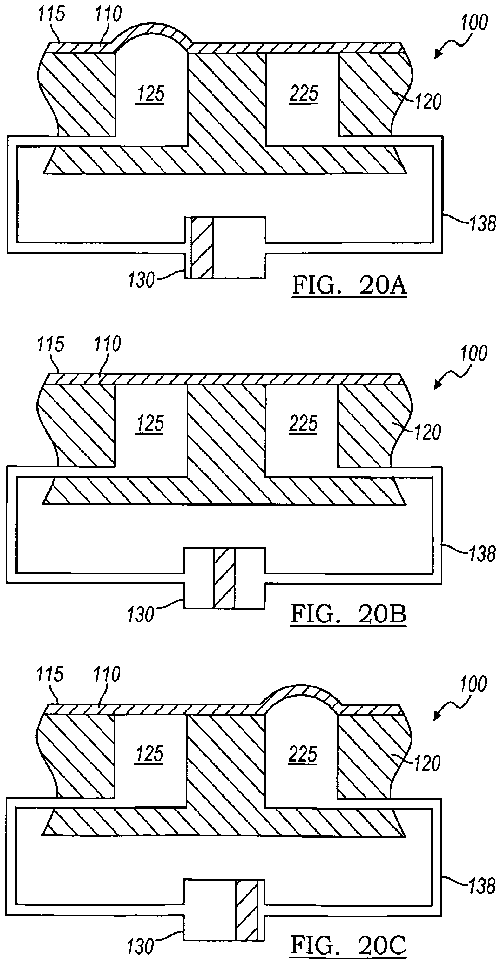

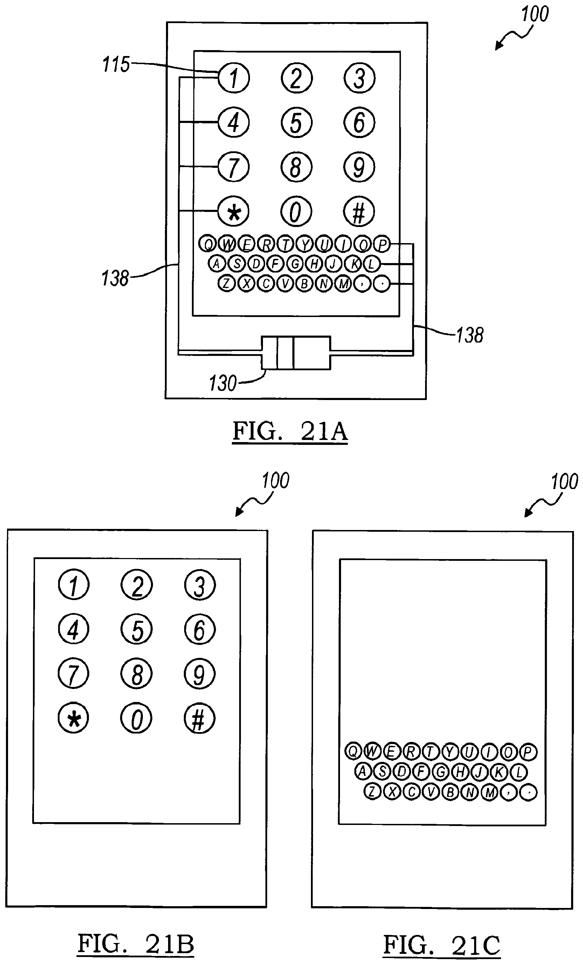

As shown in FIGURES 1 and 2, the user interface system 100 of the preferred embodiment also includes a second cavity. The additional cavities, except as detailed below, are preferably identical to the cavity 125. In one version, as shown in FIGURES 18a and 18b, the displacement device 130 is connected to both the cavity 125 and the second cavity 225 and is adapted to expand the cavity 125 and the second cavity 225 together, acting together as an array, thereby deforming more than one region of the surface 115 at the same time. In a second version, the user interface system 100 includes a valve located between the displacement device 130 and the cavity 125 and another valve located between the displacement device 130 and the second cavity 225 to selectively control the fluid flow into the cavity 125 and into the second cavity 225, respectively. In a third version, as shown in FIGURES 19a and 19b, the user interface system 100 includes a second displacement device 230 connected to the second cavity 225, which functions to expand the second cavity 225 and thereby deforming a second region of the surface 115. The second displacement device 230 is otherwise similar or identical to the displacement device 130. By separately controlling the displacement device 130 and the second displacement device 230, the cavity 125 and the second cavity 225 may be expanded independently. In a fourth version, as shown in FIGURES 20a, 20b, and 20C, the displacement device 130 is a linear actuator that can either expand the cavity 125 and retract the second cavity 225 (shown in FIGURE 20a), retract the cavity 125 and the second cavity 225 (shown in FIGURE 20b), or retract the cavity 125 and expand the second cavity 225 (shown in FIGURE 20c). This arrangement may be particularly useful in large arrays of cavities, as shown in FIGURE 21a, where the cavities aligned with a dial pad can be expanded (as shown in FIGURE 21b) or the cavities aligned with a QUERTY keyboard can be expanded (as shown in FIGURE 21c).

### 6. Power Source

The user interface system 100 of the preferred embodiments also includes either a power source or a power harnessing device, which both function to power the displacement device 130 (and possibly other elements of the user interface system, such as the touch sensor 140 and/or the display 150). The power source is preferably a conventional battery, but may be any suitable device or method that provides power to the displacement device 130. The power-harnessing device, which is preferably integrated into the hinge of a flip phone or laptop, functions to harness a portion of the energy involved in the normal use of the electronic device (such as the opening of a flip phone or the screen on a laptop). The power-harnessing device may alternatively be integrated in a separate mechanical input device (such as a button on the side of a mobile phone, or a "self-winding" device found in automatic watches) or any other suitable device or method to harness a portion of the energy involved in the normal use of the electronic device.

### 7. Alternative Embodiments

.. The user interface system of an alternative embodiment of the invention omits the display 150. The user interface system of the alternative embodiment is otherwise similar or identical to the user interface system 100 of the preferred embodiment. The user interface system of the alternative embodiment can be incorporated into electronic devices that do not typically include a display, such as peripheral for an electronic device. Suitable peripherals include a mouse, a trackpad, a keyboard, and a remote control. These peripherals are often used only by touch, and not by sight. The user interface system may, however, be incorporated in any suitable device.

As a person skilled in the art of user interfaces will recognize from the previous detailed description and from the figures and claims, modifications and changes can be made to the preferred embodiments of the invention without departing from the scope of this invention defined in the following claims.

Particular features of aspects of embodiments which are not claimed can be summarised as follows, and as a user interface system, comprising: a layer defining a surface; a substrate supporting the layer and at least partially defining a cavity; a displacement device coupled to the cavity and adapted to expand the cavity thereby deforming a particular region of the surface; and a touch sensor coupled to the substrate and adapted to sense a user touch proximate the particular region of the surface.

The layer is preferably generally elastic.

The surface may be substantially continuous.

The substrate and the layer cooperately define the cavity. The layer and the substrate are preferably formed as singular structure. The cavity may have at least two volumetric settings: a retracted volume setting and an extended volume setting.

The surface is preferably substantially planar, and the cavity extends beyond the plane of the surface in the extended volume setting.

The cavity includes a fluid. The displacement device is preferably adapted to modify the volume of the fluid to expand the cavity. The displacement device may include a heating element to heat the fluid to modify the volume of the fluid. The displacement device is preferably connected to the cavity and is adapted to displace additional fluid into the cavity to expand the cavity. The interface system may further comprise a reservoir adapted to contain additional fluid, and a channel connecting the reservoir and the cavity, wherein the displacement device displaces additional fluid from the reservoir, through the channel, and into the cavity to expand the cavity. The displacement device may be a linear actuator. At least a segment of the channel may be a micro-fluidic channel.

The deformation may be a button, and wherein the touch sensor is adapted to sense a user touch that deforms the button. The button may include a substantially dome-shaped protrusion.

Alternatively the deformation is a guide, and wherein the touch sensor is adapted to sense a user touch at different locations on the surface adjacent the guide. The guide may include a substantially ridge shaped protrusion. Moreover the guide may include two substantially ridge shaped protrusions.

The substrate may be located between the layer and the touch sensor.

The touch sensor may include the layer that defines the surface. The touch sensor may comprise a capacitance touch sensor.

The user interface system may further comprise a processor coupled to the touch sensor and adapted to operate the user interface system in at least the following two modes: a first mode if the particular region of the surface is deformed, then a user touch that further deforms the particular region of the surface is recognized as a user input of a first type; and a second mode if the particular region of the surface is not deformed, then a user touch at the particular region in the surface is not recognized as a user input of the first type.

The first mode may be further defined as: if the particular region of the surface is deformed, then a user touch that does not substantially further deform the particular region of the surface is not recognized as a user input of the first type.

The second mode may be further defined as: if the particular region of the surface is not deformed, then a user touch at the particular region in the surface is recognized as a user input of a second type that is distinguishable from the first type.

The user interface system may further comprise a display coupled to the substrate. The display may be adapted to visually output at least two images, wherein one image includes an image of input key substantially aligned with the particular region of the surface deformable by the cavity. The display and the touch sensor are preferably integrated as a single device. The display may include the layer that defines the surface. The substrate is preferably located between the layer and the display.

The cavity preferably holds a fluid, and wherein the fluid and the substrate are substantially transparent. The fluid and the substrate may have substantially similar refractive indexes.

The substrate may at least partially define a second cavity, wherein the displacement device is also connected to the second cavity and adapted to expand both the first cavity and the second cavity thereby deforming two regions of the surface. The user interface may further comprise a second displacement device connected to the second cavity and adapted to expand the second cavity thereby deforming a second region of the surface.

In a particular aspect the user interface system, comprises an elastic layer defining a substantially continuous and substantially planar surface; a substrate supporting the layer and at least partially defining a cavity that holds a fluid and that has at least two volumetric settings: a retracted volume setting and an extended volume setting; a displacement device coupled to the cavity and adapted to modify the volume of the fluid thereby expanding the cavity from the retracted volume setting to the extended volume setting, wherein the cavity in the extended volume setting extends beyond the plane of the surface thereby deforming a particular region of the surface; a touch sensor coupled to the substrate and adapted to sense a user touch proximate the particular region of the surface; a display coupled to the substrate and adapted to visually output at least two images, wherein one image includes an image of input key substantially aligned with the particular region of the surface deformable by the cavity, wherein the substrate is located between the layer and the display, and wherein the fluid and the substrate are substantially transparent and are substantially index matched; and a processor coupled to the touch sensor and adapted to operate the user interface system in at least the following two modes: a first mode if the particular region of the surface is deformed, then a user touch that further deforms the particular region of the surface is recognized as a user input of a first type; and a second mode if the particular region of the surface is not deformed, then a user touch at the particular region in the surface is recognized as a user input of a second type that is distinguishable from a user input of the first type.

The user interface system may comprise part of an electronic device for example an automotive console, a desktop computer, a laptop computer, a tablet computer, a television, a radio, a desk phone, a mobile phone, a PDA, a personal navigation device, a personal media player, a camera, and a watch. The user interface system may comprise part of a peripheral for an electronic device. The peripheral may for example be a mouse, a trackpad, a keyboard, or a remote control.

## Claims

1. A user interface system (100), comprising:
- a layer (110) defining a surface (115) that interfaces with a user in a tactile manner, the surface (115) comprises a particular region;
- a substrate (120) supporting the layer (110) and at least partially defining a cavity (125);
- a volume of fluid contained within the cavity (125);
- a fluid displacement device (130) coupled to the cavity (125) and adapted to modify the volume of fluid to expand the cavity (125) and deform the particular region from a retracted setting planar with the surface (115) to an expanded volume setting in which the particular region is extended above the plane of the surface (115);
- wherein the substrate (120) includes a support member (160) arranged underneath the layer (110), the support member (160) provides support to the layer (110) to prevent deformation of the particular region of the surface (115) below the plane of the surface (115) when the cavity is not expanded;
- a touch sensor (140) coupled to the substrate (120) and adapted to sense a user touch on the particular region of the surface (115); **characterized by**
- a display (150) arranged under the substrate (120) and outputting a graphic aligned with the particular region of the surface (115); and
- wherein the support member (160) includes holes or channels positioned above the cavity (125).

2. The user interface system (100) of Claim 1, wherein the support member (160) is integrally formed with the substrate (120).

3. The user interface system (100) of any preceding Claim, wherein the support member (160) is arranged within the cavity (125).

4. The user interface (100) of any preceding Claim, wherein the layer (110) includes a first side that defines the surface (115) and an opposite side that includes a portion that is attached to the substrate (120), thereby cooperating with the substrate (120) to substantially define the cavity (125).

## Patentansprüche

1. Benutzeroberflächensystem (100), das Folgendes umfasst:
- eine Schicht (110), die eine Oberfläche (115) definiert, die als Schnittstelle mit einem Benutzer auf taktile Weise fungiert, wobei die Oberfläche (115) eine bestimmte Region umfasst;
- ein Substrat (120), das die Schicht (110) trägt und wenigstens teilweise einen Hohlraum (125) definiert;
- ein in dem Hohlraum (125) enthaltenes Fluidvolumen;
- eine Fluidverdrängungsvorrichtung (130), die mit dem Hohlraum (125) gekoppelt und zum Verändern des Fluidvolumens ausgelegt ist, um den Hohlraum (125) auszudehnen und die bestimmte Region von einer zurückgezogenen Konfiguration planar mit der Oberfläche (115) in eine ausgedehnte Volumenkonfiguration zu verformen, in der die bestimmte Region über der Ebene der Oberfläche (115) erweitert ist;
- wobei der Substrat (120) ein Trägerelement (160) aufweist, dass unterhalb der Schicht (110) angeordnet ist, wobei das Trägerelement (160) die Schicht (110) abstützt, um eine Verformung der jeweiligen Region der Oberfläche (115) unter der Ebene der Oberfläche (115) zu verhindern, wenn der Hohlraum nicht ausgedehnt ist;
- einen Berührungssensor (140), der mit dem Substrat (120) gekoppelt und zum Erfassen einer Benutzerberührung auf der bestimmten Region der Oberfläche (115) ausgelegt ist; **gekennzeichnet durch**
- ein Display (150), das unter dem Substrat (120) angeordnet ist und eine Grafik ausgibt, die mit der bestimmten Region der Oberfläche (115) ausgerichtet ist; und
- wobei das Trägerelement (160) Löcher oder Kanäle aufweist, die über dem Hohlraum (125) positioniert sind.

2. Benutzeroberflächensystem (100) nach Anspruch 1, wobei das Trägerelement (160) einstückig mit dem Substrat (120) ausgebildet ist.

3. Benutzeroberflächensystem (100) nach einem vorherigen Anspruch, wobei das Trägerelement (160) in dem Hohlraum (125) angeordnet ist.

4. Benutzeroberfläche (100) nach einem vorherigen Anspruch, wobei die Schicht (110) eine erste Seite, die die Oberfläche (115) definiert, und eine gegenüberliegende Seite mit einem Abschnitt aufweist, der an dem Substrat (120) angebracht ist, um dadurch mit dem Substrat (120) zusammenzuwirken, um den Hohlraum (125) im Wesentlichen zu definieren.

## Revendications

1. Système d'interface utilisateur (100), comprenant :
- une couche (110) définissant une surface (115) qui s'interface avec un utilisateur de manière tactile, la surface (115) comprenant une région particulière ;
- un substrat (120) supportant la couche (110) et définissant au moins partiellement une cavité (125) ;
- un volume de fluide contenu dans la cavité (125) ;
- un dispositif de déplacement de fluide (130) couplé à la cavité (125) et adapté pour modifier le volume de fluide afin de dilater la cavité (125) et déformer la région particulière d'une configuration rétractée plane avec la surface (115) en une configuration de volume dilaté dans laquelle la région particulière est étendue au-dessus du plan de la surface (115) ;
- dans lequel le substrat (120) comporte un élément de support (160) agencé en dessous de la couche (110), l'élément de support (160) fournissant un support à la couche (110) afin d'empêcher une déformation de la région particulière de la surface (115) en dessous du plan de la surface (115) quand la cavité n'est pas dilatée ;
- un capteur tactile (140) couplé au substrat (120) et adapté pour détecter un toucher d'utilisateur sur la région particulière de la surface (115) ; **caractérisé par**
- un afficheur (150) agencé sous le substrat (120) et produisant en sortie un graphique aligné avec la région particulière de la surface (115) ; et
- dans lequel l'élément de support (160) comporte des trous ou canaux positionnés au-dessus de la cavité (125).

2. Système d'interface utilisateur (100) selon la revendication 1, dans lequel l'élément de support (160) fait partie intégrante du substrat (120).

3. Système d'interface utilisateur (100) selon l'une quelconque des revendications précédentes, dans lequel l'élément de support (160) est agencé dans la cavité (125).

4. Interface utilisateur (100) selon l'une quelconque des revendications précédentes, dans lequel la couche (110) comporte un premier côté qui définit la surface (115) et un côté opposé qui comporte une partie qui est attachée au substrat (120), coopérant ainsi avec le substrat (120) pour sensiblement définir la cavité (125).
